# FASCICULE DE BREVET EUROPEEN

(11) **EP 3 411 907 B1**
(45) Date de publication et mention de la délivrance du brevet: **14.02.2024**
(21) Numéro de dépôt: 17702120.1
(22) Date de dépôt: 01.02.2017
(51) Int. Cl.: H01L 31/0224

(54) **DISPOSITIF MULTICOLORE DE CONVERSION D'ÉNERGIE ET PROCÉDÉ DE STRUCTURATION TRIDIMENSIONNELLE DES COUCHES MINCES**
MEHRFARBIGE ENERGIEUMWANDLUNGSVORRICHTUNG UND VERFAHREN ZUR DREIDIMENSIONALEN STRUKTURIERUNG VON DÜNNSCHICHTEN
MULTICOLOR ENERGY CONVERSION DEVICE, AND METHOD FOR THREE-DIMENSIONAL STRUCTURING OF THIN FILMS

(30) Priorité: 02.02.2016 FR 1650813
(43) Date de publication de la demande: 12.12.2018
(73) Titulaire: Ardeje, 26000 Valence (FR); Centre National de la Recherche Scientifique, 75016 Paris (FR); Universite d'Aix-Marseille, 13007 Marseille (FR)
(72) Inventeur: ROUSSEAU, Théodulf, 26000 Valence (FR); BARRET, Mickaël, 26000 Valence (FR); PIERRON, Pascal, 26000 Valence (FR); DUCHE, David, 13397 Marseille Cedex 20 (FR); SIMON, Jean-Jacques, 13397 Marseille Cedex 20 (FR); ESCOUBAS, Ludovic, 13397 Marseille Cedex 20 (FR); ACKERMANN, Jörg, 13288 Marseille Cedex 09 (FR); MARGEAT, Olivier, 13288 Marseille Cedex 09 (FR); BEN DKHIL, Sadok, 13288 Marseille Cedex 09 (FR)
(74) Mandataire: Lavoix
(86) Numéro de dépôt international: PCT/EP2017/052134
(87) Numéro de publication internationale: WO 2017/134095

(56) Documents cités:
- WO-A1-2011/004929
- WO-A1-2013/094653
- CN-A- 103 715 277
- CN-B- 101 982 888
- CN-U- 203 218 276
- DE-U1-202012 102 494
- FR-A1- 2 990 300
- JP-A- S63 143 878
- JP-A- 2012 155 909
- TW-A- 201 248 891
- US-A1- 2015 024 539

## Description

La présente invention concerne un dispositif multicolore de conversion d'énergie et son procédé de structuration tridimensionnelle préférentiellement par impression jet d'encre. La présente invention concerne notamment des cellules ou des modules photovoltaïques multicolores en couches minces.

### État de la technique

Selon les procédés de l'état de la technique, les couches d'un dispositif de conversion d'énergie, et typiquement d'une cellule ou d'un module photovoltaïque en couches minces sont déposées par superposition d'une couche sur l'autre. Le dépôt de ces couches peut s'effectuer selon différentes techniques comme par exemple par dépôt chimique en phase vapeur assisté par plasma (PECVD), évaporation thermique ou enduction.

Selon les procédés actuels, les dispositifs photovoltaïques présentent une épaisseur des couches généralement constante, ou bien des émetteurs sélectifs avec une concentration de dopage plus importante localement pour favoriser un contact ohmique de faible résistance et une concentration moins importante et constante sur la majeure partie de l'émetteur pour minimiser la recombinaison des porteurs, ou bien encore des couches antireflet texturées en surface (cône, pyramide) pour favoriser l'absorption des photons. Ces faibles variations locales d'épaisseur nécessitent au moins une étape technologique supplémentaire et ont peu d'incidence sur la couleur. Typiquement une cellule photovoltaïque inorganique en couche mince présente une couleur très foncée, en générale proche du noir.

DE 20 2012 102494 décrit une cellule solaire comportant au moins une couche d'interférence, ayant au moins une première sous-zone et une seconde sous-zone, la couche d'interférence présentant une épaisseur différente, un matériau différent et/ou une composition de matériau différente dans les sous-zones partielles, de sorte qu'elles présentent des impressions de couleur différentes.

JP 2012 155909 concerne des cellules solaires à pigments photosensibles comprenant une couche conductrice transparente; une ou plusieurs couches semi-conductrices poreuses placées sur la couche conductrice transparente et comprenant un colorant sensibilisé ; une contre-électrode placée en face des couches semi-conductrices poreuses ; et une couche d'électrolyte placée entre les couches semi-conductrices poreuses et la contre-électrode.

WO 2013/094653 décrit des cellules solaires à pigment photosensible comprenant notamment une électrode recouverte d'une couche semi-conductrice d'oxyde recouverte d'un agent sensibilisant.

WO 2011/04929 concerne une méthode de fabrication d'une cellule solaire colorée comprenant : une première étape d'alignement d'un masque sur une partie supérieure d'une cellule ; une deuxième étape de revêtement d'acides phosphoriques en différentes épaisseurs sur la partie supérieure de la cellule sur laquelle le masque est aligné ; une troisième étape de formation d'une couche d'oxyde par étalement et oxydation par voie humide des acides phosphoriques simultanément lorsque les acides phosphoriques sont entièrement recouverts ; et une quatrième étape de formation d'une électrode sur une surface de la plaquette.

JP S63 143878 concerne une cellule solaire au silicium avec un film conducteur transparent d'ITO obtenu grâce à l'utilisation d'un masque métallique.

CN 103 715 277 décrit un assemblage photovoltaique coloré fait avec un dispositif solaire photovoltaique, comprenant des cellules photovoltaiques ayant à leur surface un film anti-réflexion optique.

TW 201 248 891 concerne une cellule photovoltaïque comprenant un substrat, une première électrode, une couche photovoltaïque et une seconde électrode. La première électrode comprend un gradient coloré, qui change selon l'épaisseur.

CN 101 982 888 décrit un procédé de préparation d'une cellule photovoltaïque colorée, dans lequel une couche anti-réflexion est appliquée sur une couche siliconée, et la variation d'épaisseur de cette couche anti-réflexion est contrôlée, de telle sorte que les cellules présentent différentes couleurs.

CN 203 218 276 concerne un matériau spécifique, à base de silice et HgCdTe.

FR 2 990 300 décrit un module photovoltaïque comprenant un substrat transparent ou translucide, supportant une pluralité de cellules photovoltaïques juxtaposées selon un agencement, une cellule photovoltaïque comprenant au moins une couche active interposée entre deux couches d'électrode avec des couches d'interface, le module photovoltaïque ayant une surface active délimitée présente un effet visuel final voulu autre qu'une matrice monochrome de lignes et de colonnes.

US2015/024539 décrit des solutions colloïdales de nanoparticules, pouvant être utilisées dans la fabrication de dispositifs photovoltaïques.

Il existe des modules multicolores assemblant différentes cellules photovoltaïques, cependant ces modules sont des assemblages de bandes monochromes utilisant des matériaux différents pour produire les multiples couleurs. Actuellement, il n'existe pas de cellules photovoltaïques présentant des variations de couleur, soit en d'autres termes des cellules multicolores. Or de tels dispositifs seraient très intéressants car ils permettraient d'obtenir un effet visuel optique et/ou esthétique auxquels les utilisateurs seraient sensibles et permettraient différentes applications. Actuellement, il est connu que la couleur est fonction de l'épaisseur de la couche active ou de la couche formant l'espaceur optique (« optical spacer »), mais elle reste identique sur l'ensemble de la surface de la cellule photovoltaïque, en particulier d'une cellule solaire hybride à base de polymères/ZnO (Solar En. Mat. & Solar Cells, 2014, 126 (2014) 197-204).

Ainsi actuellement, un dispositif de conversion d'énergie, et en particulier un dispositif photovoltaïque, ne peut présenter qu'une couleur. Il existe donc un besoin de proposer de nouveaux dispositifs de conversion d'énergie, et en particulier de dispositifs photovoltaïques répondant aux demandes des utilisateurs en termes d'effet visuel optique et/ou esthétique.

Par ailleurs, un dispositif de conversion d'énergie, et en particulier un dispositif photovoltaïque, présentant une variation de couleur permettrait de moduler la conversion énergétique en fonction de la couleur.

### But de l'invention

Ainsi, la présente invention a pour but de résoudre le problème technique consistant à fournir un dispositif de conversion d'énergie, et en particulier un dispositif photovoltaïque, multicolore, et son procédé de préparation.

La présente invention a aussi pour but de résoudre le problème technique de manière fiable, industrielle, et en limitant les coûts de production.

La présente invention a aussi pour but de résoudre le problème technique en conservant un bon rendement de conversion énergétique, et en particulier de photo-conversion.

### Description de l'invention

La présente invention concerne un dispositif photovoltaïque tridimensionnel selon la revendication 1.

Suivant des modes de réalisation spécifiques, ce dispositif photovoltaïque comprend une ou plusieurs des caractéristiques des revendications 2 à 6 lorsqu'une telle combinaison est techniquement possible.

L'invention revendiquée concerne aussi un procédé d'impression selon la revendication 7.

Suivant un mode de réalisation particulier, le procédé d'impression comporte une ou plusieurs des caractéristiques des revendications 8 et 9 lorsqu'une telle combinaison est techniquement possible.

L'invention revendiquée concerne aussi un module d'assemblage selon la revendication 10.

L'invention porte également sur un article selon la revendication 11.

Suivant des éléments spécifiques ne faisant pas nécessairement partie de l'invention puisque celle-ci est définie par les revendications précédemment citées, la présente description décrit de manière générale un dispositif tridimensionnel de conversion d'énergie. Comme indiqué ce dispositif qui sera dénommé dispositif décrit dans la description ne préjuge pas de la portée de l'objet revendiqué, celle-ci étant uniquement délimitée par la portée des revendications. L'ensemble des éléments décrits dans la description initiale ont été conservés pour assurer la meilleure information possible des tiers.

Le dispositif décrit dans la description comprend plusieurs couches tridimensionnelles, dont une ou plusieurs couches tridimensionnelles présentant une épaisseur variable, ledit dispositif tridimensionnel présentant plusieurs couleurs, la couleur variant en fonction de l'épaisseur d'une ou plusieurs couches présentes. De préférence, lesdites couleurs sont observées par transmission ou par réflexion.

Plus particulièrement, la description décrit donc aussi l'utilisation d'une ou plusieurs couches de matériaux structurées (ou fabriquées) avantageusement par impression jet d'encre, de préférence en contact direct ou indirect avec une couche photo-active, pour apporter une variation de couleur de l'empilement de couches.

La variation de couleur est perceptible à l'œil nu par un être humain.

Par « variations d'épaisseur » on entend que l'épaisseur varie selon l'endroit considéré de la couche. Plus précisément, le dispositif selon la présente description est tridimensionnel en ce sens que sa forme peut être définie selon des coordonnées (x,y,z) dans un référentiel XYZ. Ainsi, l'épaisseur z d'une ou plusieurs couches du dispositif varie selon sa position (x,y) dans le référentiel XYZ. Selon une variante, chaque point du dispositif tridimensionnel selon la présente description peut présenter une coordonnée (xo,yo,zo) dans le référentiel XYZ, z_{D} variant selon (x_{D},y_{D}).

Ainsi, dans le dispositif décrit dans la description, l'épaisseur n'est pas constante sur toute la surface de la couche considérée.

Le dispositif décrit dans la description peut comprendre une ou plusieurs couches d'épaisseur constante.

La variation d'épaisseur d'une ou plusieurs couches peut être continue ou discontinue. Selon une variante, le dispositif décrit dans la description comprend une variation locale d'épaisseur.

Par « multicolores » on entend au moins deux couleurs différentes, et de préférence plusieurs couleurs différentes. Par « multicolore », on entend également un gradient ou des gradients entre 2 couleurs ou plusieurs couleurs. On peut définir une couleur dans l'espace colorimétrique CIE L*a*b*, souvent abrégé CIELAB, défini par la Commission internationale de l'éclairage (CIE). On peut également définir une couleur selon le modèle TSL (Teinte Saturation Luminosité, en anglais HSL pour *Hue Saturation Lightness*) ou selon le modèle TSV (Teinte Saturation Valeur, en anglais HSV pour *Hue Saturation Value* ou HSB pour *Hue Saturation Brightness,* selon le modèle TSB, ou encore selon le modèle RVB (Rouge-Vert-Bleu), ou par extension RVBA ou RGBA (Rouge Vert Bleu Alpha, en anglais *Red Green Blue Alpha*) représentant le codage d'une couleur avec gestion de l'opacité (alpha).

Dans l'espace CIELAB, deux couleurs différentes présentent des coordonnées différentes. Avantageusement, les couleurs du dispositif décrit dans la description présente une nette distinction (visible à l'œil nu) et peuvent être un couple choisi parmi une association de bleu, vert, jaune, rouge ou l'un quelconque de leurs gradients.

Selon une variante, les couleurs présentent des composantes a* et/ou b* dans l'espace CIELAB différentes, en particulier différente à l'oeil nu.

Selon une variante, les couleurs présentent des composantes L* dans l'espace CIELAB différentes, en particulier différente à l'oeil nu.

Par analogie, selon les autres modèles de définition d'une couleur, deux couleurs sont différentes lorsqu'au moins l'un des paramètres les caractérisant est différent.

Selon une variante, la différence de couleur est obtenue par une différence d'absorption par le matériau de la lumière.

Selon une variante, la différence de couleur est obtenue par une différence de transmission par le matériau de la lumière.

Selon une variante, la différence de couleur est obtenue par une différence de réflexion par le matériau de la lumière.

Selon une variante, la variation d'épaisseur comprend un ou plusieurs gradients d'épaisseur ou différents niveaux d'épaisseurs au sein d'une ou plusieurs couches.

De manière générale, il est possible que la couche dont l'épaisseur varie soit choisie parmi le groupe consistant de : une couche photo-active, une couche formant hétérojonction P, une couche formant hétérojonction N, un substrat, une couche formant électrode inférieure, une couche formant matériau encapsulant inférieur de l'électrode inférieure (« bottom encapsulant »), une couche formant électrode supérieure, une couche formant matériau encapsulant de l'électrode supérieure (« top encapsulant »), une couche additionnelle réalisée sur l'un des encapsulants ou le substrat, et l'une quelconque de leurs combinaisons. Le gradient d'épaisseur peut être un gradient défini sur toute la couche considérée ou localisé, continu ou discontinu (discret), constant ou variant notamment en fonction de la position x et/ou y (par exemple ici x_{D} et/ou y_{D}, dans le référentiel XYZ).

De préférence, le dispositif telle que décrit dans la description comprend au moins une couche photo-active, une couche formant hétérojonction P et une couche formant hétérojonction N. De préférence, la couche dont l'épaisseur varie est choisie parmi la couche photo-active, la couche formant hétérojonction P et la couche formant hétérojonction N.

Selon une variante, le dispositif décrit dans la description peut présenter une épaisseur z_{D} sensiblement constante. Ainsi, dans le référentiel XYZ, l'épaisseur z d'une ou plusieurs couches varie selon les coordonnées x_{D} et y_{D}.

Selon une variante, l'épaisseur z d'une ou plusieurs couches varie uniquement selon x_{D}. On peut ainsi former des lignes de différentes couleurs selon x_{D}.

Selon une autre variante, l'épaisseur z d'une ou plusieurs couches varie uniquement selon y_{D}. On peut ainsi former des lignes de différentes couleurs selon y_{D}.

Avantageusement, la variation d'épaisseur z définit un motif visible à l'oeil nu d'un être humain. Il peut par exemple s'agir d'un ou plusieurs caractères alphanumériques et/ou d'une ou plusieurs représentations graphiques.

Selon une variante, dans le cas d'un dispositif photovoltaïque inorganique en couches minces, le dispositif comprend une couche de type P ou N comprenant une ou plusieurs variations d'épaisseur.

Selon une autre variante, dans le cas d'un dispositif photovoltaïque organique OPV en couches minces, le dispositif comprend une couche photo-active composée de deux couches (dénommée hétérojonction planaire ou bi-couches ou encore « bilayer ») comprenant une ou plusieurs variations d'épaisseur.

Selon une autre variante, dans le cas d'un dispositif photovoltaïque organique OPV en couches minces, le dispositif comprend une couche photo-active (dénommée hétérojonction volumique ou « Bulk-heterojunction ou encore BHJ ») comprenant une ou plusieurs variations d'épaisseur.

Selon une autre variante, dans le cas d'un dispositif photovoltaïque hybride organique-inorganique en couches minces, le dispositif comprend une couche photo-active comprenant une ou plusieurs variations d'épaisseur.

Selon une autre variante, dans le cas d'un dispositif photovoltaïque hybride multijonction en couches minces, le dispositif comprend une couche photo-active comprenant une ou plusieurs variations d'épaisseur.

Selon une variante, la couche de type P est une couche d'un ou plusieurs matériaux choisis parmi les oxydes métalliques telle V2O5, WO3, MoOx, MoO3 ou parmi les polymères conducteurs organiques tel le PEDOT:PSS (mélange de poly(3,4-éthylènedioxythiophène) (PEDOT) et de polystyrène sulfonate) de sodium (PSS)), ou encore le 2,2',7,7'-Tetrakis(N,N-di-p-methoxyphenylamine)-9,9'-spirobifluorene (spiro-OMeTAD).

Selon une variante, la couche photoactive est formée d'une hétérojonction de semiconducteurs inorganiques choisis parmi les matériaux suivants CdTe/CdS, CdSe/CdS, CdS/CulnGaSe2 (CIGS), ZnS/CulnGaSe2 (CIGS),
Selon une variante, le dispositif tel que décrit comprend une couche de matériau organique comprenant une ou plusieurs variations d'épaisseur.

Selon une variante, la couche de type N est une couche d'un ou plusieurs matériaux choisis parmi les oxydes métalliques ZnO, AZO, TiO2, TiOx, NiO, Cs2CO3, les oxydes de graphène GO ou parmi les matériaux organiques tel que le poly[(9,9-bis(3'-(N,N-dimethylamino)propyl)-2,7-fluorene)-alt-2,7-(9,9-dioctyl-fluorene)] (PFN).

Selon une variante, dans le cas d'un dispositif OPV, la couche photo-active de matériaux semi-conducteurs organiques est formée d'une hétérojonction planaire de matériau donneur et accepteur d'électrons (aussi dénommée « bicouche ou bilayer »). Selon une variante, dans le cas d'un dispositif OPV, la couche photo-active de matériaux semi-conducteurs organiques est formée d'un mélange de matériau donneur et accepteur d'électrons (aussi dénommée « Bulk-heterojunction ou BHJ »).

Selon une variante, dans le cas d'un dispositif photovoltaïque hybride, la couche photo-active est formée de bicouche ou de mélange de matériaux hybrides organique-inorganiques.

Plus particulièrement, on peut citer les matériaux polymères donneurs comme par exemple les dérivés du polyphénylène vinylène PPV, les dérivés de polythiophène (le P3HT (poly(3- hexylthiophène), polythiophène et ses dérivés, copolymères de polythiophène ou polycarbazole) polyfluorene, cyclobenzadithiophene, les donneurs polymère a transfert de charge interne comme thienothiophene et benzodithiophene, les polymères à base de dicetopyrrolopyrrole DPP, famille des PTB (le PTB7 (Poly({4,8-bis[(2-ethylhexyl)oxy]benzo[1,2-b:4,5-b']dithiophene-2,6-diyl}{3-fluoro-2-[(2-ethylhexyl)carbonyl]thieno[3,4-b]thiophenediyl})).

En plus, on peut citer les matériaux chromophores moléculaires donneurs comme les phtalocyanines, la chlorophylle A, les squaraines, mérocyanines, lesdonneurs moléculaires à transfert de charge interne comme les oligothiophene, dérivés d'indigo, dicétopyrrolopyrrole ou triphénylamine.

En plus, on peut citer les matériaux hybrides donneur comme la famille des perovskites, et les matériaux accepteur tel les dérivés solubles du fullerène, PC₆₁BM, PC₇₁BM, les dérivés des pérylène diimide PDI et pérylene tétracarboxylique bisbenzimidazole PTCBI, polymères semi-conducteurs de type n, etc utilisés pour la fabrication des cellules photovoltaïques organiques.

Ainsi, de préférence, le dispositif tel que décrit est tel que :
- la couche de type P est une couche d'un ou plusieurs matériaux choisis parmi les oxydes métalliques tel le V2O5, WO3, MoOx, MoO3 ; les polymères conducteurs organiques tel le mélange de poly(3,4-éthylènedioxythiophène) et de polystyrène sulfonate) de sodium (PEDOT :PSS)) ; et le spiro-OMeTAD ; et/ou
- la couche de type N est une couche d'un ou plusieurs matériaux choisis parmi les oxydes métalliques ZnO, AZO, TiO2, TiOx, NiO, Cs2CO3 ; les oxydes de graphène ; et les matériaux organiques ; et/ou
- la couche photoactive est formée d'une hétérojonction de semiconducteurs inorganiques choisis parmi les matériaux suivants CdTe/CdS, CdSe/CdS, CdS/CulnGaSe2 (CIGS), ZnS/CulnGaSe2 (CIGS) ; ou bien est formée d'une hétérojonction planaire de matériaux semi-conducteurs organiques donneur et accepteur d'électrons (aussi dénommée « bicouche ou bilayer ») ; ou bien est formée d'un mélange de matériaux semi-conducteurs organiques donneur et accepteur d'électrons (aussi dénommée « Bulk-heterojunction ou BHJ ») ; ou bien est formée de bicouche ou de mélange de matériaux hybrides organique-inorganiques.

Le matériau à imprimer est mis en oeuvre en solution, formulé sous forme d'encre, puis déposé, en particulier par impression jet d'encre à travers une ou plusieurs buses d'impression. Selon une variante, le matériau est formulé sous forme d'encre. L'encre du matériau à imprimer présente des propriétés physico-chimiques suffisantes pour être imprimable, c'est-à-dire par exemple d'être éjecté au travers d'une ou plusieurs buses d'un module d'impression, puis de solidifier une fois déposée. Les propriétés de l'encre peuvent être ajustées de manière à optimiser la qualité d'impression. En général, on ajuste spécifiquement la viscosité de l'encre et la tension superficielle pour son impression sur le support sélectionné, et ses caractéristiques de solidification/séchage sont optimisées après dépôt. On peut utiliser des formulations commercialement disponibles ou optimiser des formulations spécialement pour l'impression jet d'encre. On peut notamment valider une formulation en fonction des caractéristiques des gouttes obtenues lors de son éjection et des paramètres de pilotage. Avantageusement, une technologie d'impression jet d'encre Drop-On-Demand piézoélectrique est utilisée. Les paramètres permettant de régler les caractéristiques des gouttes lors de l'éjection sont alors la forme d'onde d'excitation de l'élément piézoélectrique, la pression, la température, la fréquence d'éjection, ...etc

Avantageusement, le dispositif est un ensemble de couches formant un dispositif actif de conversion d'énergie. Par « actif », on entend qu'une énergie (par exemple des radiations lumineuses) est transformée en une autre énergie (par exemple électrique).

Selon une variante, le dispositif comprend une ou plusieurs variations de couleur dans une zone non-active pour la conversion d'énergie, et en particulier non-active pour la photo-conversion. Selon cette variante, dans le cadre de la photo-conversion, on peut ainsi optimiser l'effet optique en définissant des zones dites « mortes » électriquement dont le rendement en conversion d'énergie est sacrifié au profit de l'effet optique (ou visuel). En d'autres termes, le dispositif peut comprendre des zones « mortes » électriquement présentant un effet optique marqué et des zones « actives » électriquement comprenant un effet optique moins marqué ou absent.

Selon une variante, la variation d'épaisseur est localisée hors d'une zone de conversion électrique

Selon une variante, le dispositif décrit dans la description comprend une couche d'oxyde métallique comprenant une ou plusieurs variations d'épaisseur. De préférence, la couche photo-active du dispositif décrit dans la description est différente d'une couche d'oxyde métallique.

De manière générale, la présente description concerne un dispositif de photo-conversion et plus particulièrement un dispositif photovoltaïque en couches minces comprenant l'empilement de couches : anode/couche P/couche active/couche N/cathode.

La description concerne également un dispositif de photo-conversion et plus particulièrement un dispositif photovoltaïque comprenant l'empilement de couches cathode/couche N/couche active/couche P/anode.

Selon une variante, le dispositif est une cellule photovoltaïque en structure dite « classique », c'est-à-dire présentant l'empilement suivant des couches : électrode inférieure/P/Photoactive (I)/ N/ électrode supérieure ; l'empilement PIN étant déposé sur l'électrode positive. Selon une variante, le dispositif est une cellule photovoltaïque en structure dite « inverse », c'est-à-dire présentant l'empilement suivant des couches : électrode inférieure/N/photoactive (I)/ P/ électrode supérieure ; l'empilement NIP étant déposé sur l'électrode négative. Dans les 2 cas, au moins 1 des électrodes doit être semi-transparente pour laisser passer la lumière. Selon une variante, les 2 électrodes peuvent être semi-transparentes pour laisser passer la lumière. Selon une variante les dispositifs sont semi-transparents et l'aspect esthétique peut différer selon le côté sous lequel on le regarde en fonction des variations des épaisseurs d'une ou de plusieurs couches et d'une ou des sources lumineuses pouvant éclairer le dispositif d'un seul côté ou des deux côtés simultanément.

Avantageusement, le substrat est un matériau rigide ou flexible ; semi-transparent ou transparent ou opaque.

Le substrat peut être typiquement choisi parmi des films plastiques flexibles PET, PEN, polymère, tissus (« foil ») ou rigide, ou matériaux inorganiques comme par exemple en verre, etc.

Typiquement, la présente description concerne un dispositif de photo-conversion comprenant l'empilement suivant :
Substrat/ITO/PEDOT:PSS/PTB7-PCBM/ZnO/électrode métallique; ou
Substrat/ITO/PEDOT:PSS/PTB7-PCBM/AZO/ électrode métallique; ou
Substrat/ITO/ZnO/PTB7-PCBM/ PEDOT:PSS/ électrode métallique; ou
Substrat/ITO/AZO/PTB7-PCBM/ PEDOT:PSS/ électrode métallique, ou
Substrat/ITO/TiOx/PTB7-PCBM/ PEDOT:PSS/ électrode métallique.

Les électrodes (face avant ou face arrière) peuvent être typiquement choisies parmi l'ITO, FTO, SnO2 , SnO2 :F, ou des oxydes transparents conducteurs TCO (« transparent conductive oxyde), Al :ZnO, ou bien sans ITO (« ITO-free »), des grilles métalliques, des électrodes hybrides, et avantageusement les bicouches ZnO/Ag ou Pedot-Pss/Ag. Les matériaux métalliques peuvent être éventuellement dopés par d'autres éléments. Les éléments métalliques peuvent comprendre en outre des nanoparticules d'argent et/ou les nanoparticules de carbone, par exemple.

La présente description concerne un procédé d'impression par jet d'encre comprenant l'impression par jet d'encre d'une ou plusieurs couches tridimensionnelles d'un dispositif tridimensionnel de conversion d'énergie, ledit dispositif tridimensionnel comprenant plusieurs couches tridimensionnelles, dont une ou plusieurs couches présentant une épaisseur variable, ledit dispositif tridimensionnel présentant plusieurs couleurs, la couleur variant en fonction de l'épaisseur d'une ou plusieurs couches présentes.

Selon les techniques de l'art antérieur, l'épaisseur d'une couche d'un dispositif photovoltaïque n'est pas contrôlée spatialement en trois dimensions. Par conséquent, il n'existe pas de dispositif de conversion d'énergie et en particulier des dispositifs photovoltaïques comprenant une ou plusieurs couches dont l'épaisseur varie et il n'est possible d'obtenir que des dispositifs monochromes.

Parmi les procédés économiques de fabrication, le procédé jet d'encre est préféré dans la présente description. La présente description concerne donc un procédé d'impression numérique qui permet de générer un motif sur un support par éjection de gouttes d'encre (1 - 250 picolitres) à travers des orifices, nommés buses, depuis une tête d'impression.

Le procédé selon la présente description est compatible avec une large gamme de matériaux. En particulier le procédé selon la présente description est mis en oeuvre sans recours à un outillage tel un masque ni contact sur différents types de supports (verre, céramique, plastique, etc.), ce qui le rend potentiellement bas coûts.

Le procédé selon la présente description est un procédé additif qui consomme très peu de matière, ne requiert pas d'étape de nettoyage et de gravures supplémentaires, ce qui réduit considérablement le nombre d'étapes de fabrication.

Enfin le procédé selon la présente description permet un large choix de dessins, de motifs imprimés, ce qui permet une personnalisation des produits, et en particulier des dispositifs de conversion d'énergie et particulièrement des dispositifs photovoltaïques.

Les procédés d'impression jet d'encre sont subdivisés globalement en deux technologies, à savoir la technologie de gouttes à la demande ou DOD et la technologie de jet continu ou CIJ.

Selon une variante, le procédé tel que décrit dans la description est mis en oeuvre par DOD.

Dans le cas d'un procédé piézo-électrique, l'éjection du fluide est actionnée à l'aide de matériaux piézo-électriques tapissant les parois des buses qui se déforment sous l'action d'un champ électrique. Ce dernier provoque la contraction ou la relaxation des piézoélectriques, transformant ainsi un signal électrique en déplacement mécanique. Ainsi, le procédé tel que décrit dans la description est mis en oeuvre avantageusement par procédé piézo-électrique.

Selon une variante, le procédé tel que décrit dans la description concerne un procédé d'impression numérique par jet d'encre.

La structuration par impression jet d'encre d'une ou plusieurs couches du dispositif est réalisée par un dépôt avec une quantité d'encre déposée par unité de surface variable.

Avantageusement, la quantité d'encre déposée varie selon la position dans la couche considérée, par exemple en fonction de x et/ y (par exemple ici (x_{D},y_{D}) dans le référentiel XYZ).

Selon une variante, l'épaisseur est fonction du volume de gouttes, de la résolution, du tramage, du mode d'impression (par exemple binaires ou niveaux de gris), du mode de déplacement de la tête d'impression (simple ou multi-passes), du nombre de passes, et de l'une quelconque de leurs combinaisons.

Avantageusement, on peut définir une stratégie d'impression en réalisant des essais de routine préalables pour ajuster le volume des gouttes, la résolution d'impression, le tramage, le mode d'impression (binaires ou niveaux de gris, par exemple), le mode de déplacement de la tête d'impression, le nombre de passes, etc, en fonction de la couleur à générer.

Selon une variante, le volume de gouttes varie de 1 à 250 picolitres (pL). On peut par exemple utiliser des gouttes d'un volume de 5 pL, 10 pL ou 40 pL, etc.

Selon une variante, l'épaisseur varie selon la résolution d'impression. Par exemple la résolution d'impression est définie par le nombre de gouttes par unité de surface. Pour une surface donnée, la réduction de l'espacement entre les gouttes dans les deux directions x et/ y (par exemple ici selon les coordonnées des couples (x_{D},y_{D}) dans le référentiel XYZ) permet de concentrer le nombre de gouttes et par conséquent d'augmenter la résolution d'une image, et en l'occurrence ici de faire varier l'épaisseur d'une couche. Par exemple, la résolution d'impression peut varier de 150 × 150 dpi² à 6000 × 6000 dpi².

Selon une variante, l'impression est réalisée en mode binaire. Selon une autre variante, l'impression est réalisée en mode d'impression en niveaux de gris pour un matériau donné. Avantageusement, un mode d'impression en niveaux de gris permet d'utiliser différents volumes de gouttes pour générer un motif et ainsi, le reproduire plus fidèlement.

Selon un mode de réalisation, on réalise une variation d'épaisseur selon le mode de déplacement qu'il soit simple passe ou multipasses (« scanning »).

Selon une variante, l'épaisseur varie selon le nombre de passes. Le nombre de passes peut varier avantageusement de 1 à 5.

Avantageusement, selon le procédé tel que décrit dans la description, on peut imprimer une ou plusieurs couches selon le motif ou la structure envisagé. On peut réaliser des structures complexes.

Avantageusement, le procédé tel que décrit dans la description comprend un dispositif asservissant l'épaisseur z de la couche imprimée à la position de la buse dans le référentiel XYZ servant à définir la forme du dispositif de conversion d'énergie.

Selon une variante préférée, le procédé tel que décrit dans la description permet la fabrication d'un dispositif de conversion d'énergie multicolore dont la forme et la couleur sont définies dans un repère XYZ, ledit procédé comprenant :
(i) le positionnement d'un module d'impression selon un référentiel XYZ ;
(ii) éventuellement le positionnement dans le référentiel XYZ d'une ou plusieurs couches déjà empilées pour l'impression d'une ou plusieurs couches par jet d'encre ;
(iii) l'impression par jet d'encre d'une ou plusieurs couches dont l'épaisseur z varie en fonction de la position du module d'impression dans le référentiel XYZ ;
(iv) l'obtention d'un dispositif de conversion d'énergie multicolore dans lequel la couleur varie en fonction de l'épaisseur z d'une ou plusieurs couches imprimées.

Selon une variante, le procédé tel que décrit comprend la préparation d'une ou plusieurs couches par un autre procédé que celui décrit, ne faisant pas varier l'épaisseur de la couche préparée.

Le procédé tel que décrit concerne selon un aspect un procédé de fabrication comprenant la détermination du motif multicolore à imprimer.

Selon une variante, le procédé de fabrication comprend la détermination du motif multicolore selon l'épaisseur des couches formant l'empilement de couches au sein du dispositif de conversion d'énergie, et en particulier du dispositif photovoltaïque.

Avantageusement, les couleurs sont déterminées par expérience et/ou par prédiction des couleurs générées par la variation d'épaisseur d'une ou plusieurs couches. La prédiction peut par exemple se réaliser à l'aide d'un logiciel. Par exemple qu'on associe à une épaisseur d'une couche donnée les composantes dans l'espace CIELAB.

La présente demande décrit également un dispositif d'impression par jet d'encre comprenant un module d'impression d'une ou plusieurs couches d'un dispositif de conversion d'énergie, en particulier d'un dispositif de photoconversion, et en particulier d'un dispositif photovoltaïque, ledit dispositif d'impression comprenant un module de contrôle de la quantité d'encre déposée, ladite quantité d'encre déposée formant l'épaisseur d'une couche, ledit dispositif d'impression comprenant un module asservissant l'épaisseur z de la couche à imprimer en fonction de la position du module d'impression dans un référentiel XYZ servant également à définir la forme de la couche du dispositif de conversion d'énergie à imprimer.

Selon une variante, le dispositif d'impression par jet d'encre comprend un ou plusieurs réservoirs de matériaux. Avantageusement, les matériaux sont ceux formant une ou plusieurs couches d'un dispositif de photo-conversion, et en particulier d'un dispositif photovoltaïque.

Selon une variante, le dispositif d'impression par jet d'encre comprend un module de positionnement du module d'impression selon un référentiel XYZ ; éventuellement un module de positionnement d'une ou plusieurs couches empilées dans le référentiel XYZ lesdites couches empilées formant en partie un dispositif de conversion d'énergie, et plus particulièrement en partie un dispositif photovoltaïque ; un module d'impression par jet d'encre connecté, directement ou indirectement, avec un ou plusieurs réservoirs d'encre formant après dépôt une ou plusieurs couches d'un dispositif de conversion d'énergie, et en particulier d'un dispositif photovoltaïque ; un module de contrôle de l'épaisseur z de la couche d'encre déposée, ledit module de contrôle variant l'épaisseur de la couche déposée en fonction de la position du module d'impression dans le référentiel XYZ.

Avantageusement, le dispositif d'impression comprend un module de contrôle de la couleur d'un empilement de couches d'un dispositif de conversion d'énergie, et en particulier d'un dispositif photovoltaïque.

Selon une variante, le dispositif d'impression ou le procédé d'impression décrits comprend un module/logiciel de prédiction et/ou de contrôle des couleurs en fonction de l'épaisseur de la ou les couches considérées. Avantageusement le module de prédiction et/ou de contrôle des couleurs prend en compte l'ensemble des couches du dispositif tridimensionnel.

Selon une variante, le dispositif de conversion d'énergie est un dispositif photovoltaïque. Il s'agit en particulier d'un dispositif photovoltaïque comprenant ou consistant de couches, que l'on nomme en générale « couches minces » du fait de leur faible épaisseur.

Selon une variante, le dispositif de conversion d'énergie est un dispositif photovoltaïque choisi parmi les cellules photovoltaïques en silicium amorphe, les cellules photovoltaïques en silicium monocristallin, les cellules photovoltaïques en silicium polycristallin, les cellules photovoltaïques tandem, qui sont par exemple un empilement monolithique de deux cellules simples ou en combinant deux cellules (couche mince de silicium amorphe sur silicium cristallin par exemple), par exemple avec des spectres d'absorption connexes, les cellules photovoltaïques multi-jonction, les cellules photovoltaïques à base de matériaux semiconducteurs inorganiques tels diséléniure de cuivre Indium CIS, de Tellurure de Cadmium CdTe, de cuivre, d'indium, de gallium et sélénium CIGS, les cellules photovoltaïques organiques à hétérojonction planaire ou bicouche, les cellules photovoltaïques organiques à hétérojonction volumique ou « bulk-heterojonction », les cellules photovoltaïques hybrides organiques-inorganique à hétérojonction planaire ou volumique, des cellules photovoltaïques hybrides et multijonction à base de pérovskites, des cellules photovoltaïques multijonction à base de nouvelles familles de matériaux hybrides et l'une quelconque de leurs combinaison.

L'homme du métier connaît l'architecture des dispositifs photovoltaïques en couches minces. La présente description inclut différentes architectures des dispositifs de conversion d'énergie et en particulier des dispositifs photovoltaïques en couches minces. La présente description inclut les architectures multicouches suivantes
Al ou Ag/P/I/N/SnO2/Verre ou polymère
Al ou Ag/P/I/N/TCO/Verre ou polymère
Verre ou polymere/Mo/P/N/ZnO/Al :ZnO
Al ou Ag/P/I/N/SnO2/Verre ou polymère
Al ou Ag/P/I/N/TCO/Verre ou polymère
Verre ou polymere/Mo/P/N/ZnO/AZO
Verre ou polymere/électrode inférieure/P/I ou BHJ/N/AI
Verre ou polymere/électrode inférieure/N/I ou BHJ/P/Ag

Typiquement, la présente description concerne un dispositif de photo-conversion comprenant l'empilement suivant :
Verre ou polymère/ITO/PEDOT:PSS/PTB7-PCBM/ZnO/électrode métallique; ou
Verre ou polymère /ITO/PEDOT:PSS/PTB7-PCBM/AZO/ électrode métallique; ou
Verre ou polymère /ITO/ZnO/PTB7-PCBM/ PEDOT:PSS/ électrode métallique; ou
Verre ou polymère /ITO/AZO/PTB7-PCBM/ PEDOT:PSS/ électrode métallique, ou
Verre ou polymère /ITO/TiOx/PTB7-PCBM/ PEDOT:PSS/ électrode métallique.

Selon une variante, le dispositif photovoltaïque est une cellule photovoltaïque. On peut citer les cellules photovoltaïques de type PIN ou NIP. En général, une cellule photovoltaïque comprend une couche formant substrat en contact avec une électrode en générale dite « électrode inférieure », laquelle est en contact avec une couche de type N ou P, laquelle est en contact avec une couche dite photo-active (ou BHJ, « Bulk-Heterojunction »), laquelle est en contact avec une couche de type N ou P, laquelle est en contact avec une autre électrode en général dite « électrode supérieure ».

Il existe différents procédés de fabrication des dispositifs photovoltaïques. On peut les réaliser en structure dite « classique », c'est-à-dire de type PIN empilant les couches selon le sens substrat/électrode inférieure/couche P/couche photoactive/couche N/électrode supérieure. On peut les réaliser en structure dite « inverse », c'est-à-dire en empilant les couches selon le sens inverse à celui précédent, c'est-à-dire de type NIP selon le sens substrat/électrode inférieure/couche N/couche photoactive/couche P/électrode supérieure.

L'empilement des couches : P/photoactive (I)/ N ou N/I/P peut être multiple.

Le dispositif tridimensionnel peut comprendre une ou plusieurs couches de chaque type, et notamment plusieurs couches de type P, I et N, et l'une quelconque de leurs combinaisons.

La couche absorbante active ou photoactive dans le cas des OPVs, est généralement composée d'un matériau semi-conducteur de type N (comme par exemple un ou plusieurs fullerènes dopés, dérivés du fullerène (comme par exemple le PCBM (« [6,6]-phényl-C₆₁-butanoate de méthyle »), pérylène, polymères semi-conducteurs de type n, etc.) en mélange avec un matériau semi-conducteur de type P (P3HT, polythiophène et ses dérivés, copolymères de polythiophène ou polycarbazole, etc). On peut notamment se référer aux matériaux cités dans la thèse de M. T. Rousseau (HAL Id: tel-00984367 ; https://tel.archives-ouvertes.fr/tel-00984367).

La présente description inclut les architectures multicouches électroluminescentes organiques comme par exemple celles HTUETL, HTL/LEL/ETL, HIL/HTULEL/ETL, HIL/HTULEUETUEIL, HIUHTUelectron-blocking layer ou hole-blocking layer/LEL/ETUEIL, HIL/HTL/LEL/hole-blocking layer/ETL/ EIL. HTL désigne la couche transporteuse de trous (« Hole-Transporting Layer »), HIL désigne la couche injectant les trous (« Hole-Injecting Layer »), LEL désigne la couche émettrice de lumière (« Light-Emitting Layer »), EIL désigne la couche organique injectant les électrons (« Organic electron-Injecting Layer »), « electron-blocking layer » désigne une couche bloquant les électrons, « hole-blocking layer » désigne une couche bloquant les trous.

Selon une variante, le dispositif de conversion d'énergie est choisi parmi une cellule photovoltaïque, une cellule photovoltaïque de type PIN ou NIP, un transistor organique à effet de champ (OFET), ou une diode électroluminescente, une diode électroluminescente organique (OLED), une diode électroluminescente polymère (PLDE), etc.

Selon une variante, la couche d'interface (N ou P) comprend une variation discontinue d'épaisseur.

Selon une variante, la couche d'interface (N ou P) comprend un gradient d'épaisseur.

Selon une variante, la présente description concerne un dispositif photovoltaïque comprenant une variation de l'épaisseur de la couche N ou P structurée tridimensionnellement en utilisant un mode d'impression par niveaux de gris.

Avantageusement, selon le procédé décrit dans la présente description, la couche d'interface (N ou P) est structurée tridmensionnellement selon un motif déterminé. Ainsi, la couche d'interface (N ou P) peut comprendre une ou plusieurs variations d'épaisseur. Selon une variante, la couche d'interface peut comprendre une alternance d'épaisseurs.

Selon une variante, notamment pour la couche photo-active, la variation d'épaisseur peut être définie autour d'un optimum d'absorption. Avantageusement une telle impression permet de limiter l'impact sur les performances de photo-conversion. On peut définir un optimum d'absorption selon l'efficacité de photo-conversion du matériau considéré en fonction de son épaisseur. L'optimum d'absorption est défini comme l'épaisseur présentant une conversion énergétique maximum.

Selon une variante, la couche photo-active comprend une variation discontinue d'épaisseur.

Selon une variante, la couche photo-active comprend un gradient d'épaisseur.

Selon une variante, la présente description concerne un dispositif photovoltaïque comprenant une variation de l'épaisseur de la couche photo-active (BHJ) par mode d'impression en niveaux de gris.

Avantageusement, selon le procédé de la présente description, la couche photo-active est structurée selon un motif déterminé. Ainsi, la couche photo-active peut comprendre une ou plusieurs variations d'épaisseur. Selon une variante, la couche photo-active peut comprendre une alternance de variations d'épaisseur.

Avantageusement, selon le procédé de la présente description, la couche photo-active est structurée selon un motif déterminé. Ainsi, la couche photo-active peut comprendre une ou plusieurs variations d'épaisseur. Selon une variante, la couche photo-active peut comprendre une alternance d'épaisseurs.

Selon une variante, la présente description concerne un dispositif photovoltaïque comprenant une variation de l'épaisseur d'une couche en contact avec le substrat.

Selon une variante spécifique, une couche en contact avec la couche formant substrat est une couche encapsulante inférieure (bottom encapsulant).

Selon une variante spécifique, une couche en contact avec la couche formant substrat est une couche encapsulante supérieure (top encapsulant).

Selon une variante, le substrat et/ou la couche encapsulante comprennent une variation discontinue d'épaisseur.

Selon une variante, le substrat et/ou la couche encapsulante comprennent un gradient d'épaisseur.

Selon une variante, la présente description concerne un dispositif photovoltaïque comprenant une variation de l'épaisseur du substrat et/ou de la couche encapsulante par mode d'impression en niveaux de gris.

Avantageusement, selon le procédé de la présente description, le substrat et/ou la couche encapsulante sont structurées selon un motif déterminé. Ainsi, le substrat et/ou la couche encapsulante peuvent comprendre une ou plusieurs variations d'épaisseur. Selon une variante, le substrat et/ou la couche encapsulante peuvent comprendre une alternance d'épaisseurs.

Avantageusement, le substrat et/ou la couche encapsulante sont transparents ou semi-transparents.

Selon une variante, le substrat et/ou la couche encapsulante sont colorés.

Selon une variante le substrat et/ou la couche encapsulante forment une monocouche. Selon une autre variante le substrat et/ou la couche encapsulante forment une multi-couche.

Selon une variante, le substrat et/ou la couche encapsulante sont d'une couleur uniforme. Selon une autre variante, le substrat et/ou la couche encapsulante comprennent des motifs multicolores.

Avantageusement, on peut par exemple former un filtre interférentiel numérique structuré tridimensionnellement selon le procédé tel que décrit par la présente description. Avantageusement, un filtre interférentiel numérique structuré tridimensionnellement permet différentes possibilités optiques et évite l'utilisation d'un masque pour créer des motifs, et par conséquent potentiellement économique.

Selon une variante, le dispositif tel que décrit peut comprendre une ou plusieurs couches additionnelles, comme par exemple un ou plusieurs filtres interférentiels. Il peut s'agir par exemple d'encre colorée sur substrat ou couche encapsulante. Cela permet notamment de jouer sur la couleur du substrat et/ou des couches encapsulantes, et/ou leurs propriétés de réflexion, etc.

Selon une variante, le dispositif tel que décrit peut comprendre une ou plusieurs couches additionnelles imprimées selon le procédé décrit comprenant des variations de propriétés optiques. Une telle couche peut être en contact avec le substrat et/ou la couche encapsulante.

Selon une variante, le dispositif décrit peut comprendre une ou plusieurs couches comprenant un indice de réfraction élevé pour favoriser la réflexion ou faible pour optimiser l'absorption (anti-réflexion).

Selon une variante, la présente description concerne un dispositif photovoltaïque comprenant une variation de l'épaisseur d'une couche formant l'électrode.

Selon une variante, la couche formant électrode comprend une variation discontinue d'épaisseur.

Selon une variante, la couche formant l'électrode comprend un gradient d'épaisseur.

Selon une variante, la présente description concerne un dispositif photovoltaïque comprenant une variation de l'épaisseur de la couche formant l'électrode en utilisant un mode d'impression par niveaux de gris.

Avantageusement, selon le procédé de la présente description, la couche formant l'électrode est structurée selon un motif déterminé. Ainsi, la couche formant l'électrode peut comprendre une ou plusieurs variations d'épaisseur. Selon une variante, la couche formant l'électrode peut comprendre une alternance de variations d'épaisseur.

Les inventeurs ont découvert que lorsque l'on fait varier l'épaisseur de plusieurs couches, la couleur de l'empilement, et donc du dispositif de conversion d'énergie, et en particulier des dispositifs photovoltaïques, varie. Ainsi, selon une variante, une combinaison de variations d'épaisseur de couche forme une variation de couleur.

Avantageusement, la structuration en épaisseur des couches du dispositif tridimensionnel forme un motif multicolore.

Le motif multicolore peut par exemple être réalisé par la combinaison de différents matériaux présentant des indices de réfraction différents, et une épaisseur variant au sein d'une même couche.

Selon une variante, la couleur est définie par la variation de l'épaisseur d'une ou plusieurs couches de l'empilement.

Avantageusement, la description concerne en particulier un dispositif dans lequel la ou les couches les plus à l'extérieur du dispositif ne sont pas opaques, et de préférence sont transparentes, de manière à percevoir de l'extérieur (par une personne observatrice) une variation de couleur obtenue par la variation d'épaisseur des couches du dispositif.

Selon une variante, dans un dispositif comprenant un empilement de couches, une ou plusieurs couches inférieures à la première couche supérieure comprenant une variation d'épaisseur ne sont pas opaques, et de préférence transparentes, notamment de manière à laisser percevoir plusieurs couleurs.

La description concerne également un module d'assemblage de plusieurs dispositifs de conversion d'énergie, le module comprenant un ou plusieurs dispositifs de conversion d'énergie selon la présente description, ou obtenus par un procédé d'impression par jet d'encre selon la présente description.

La description concerne également un module d'assemblage de plusieurs cellules photovoltaïques, le module comprenant une ou plusieurs cellules photovoltaïques telles que précédemment décrites, ou obtenues par un procédé d'impression par jet d'encre tel que précédemment décrit.

La description concerne encore des articles comprenant un ou plusieurs dispositifs tels que précédemment décrits.

Plus particulièrement, la description concerne aussi un article comprenant un ou plusieurs dispositifs de conversion d'énergie selon la présente description, ou obtenus par un procédé d'impression par jet d'encre selon la présente description.

Selon une variante, la description concerne un article comprenant une ou plusieurs cellules photovoltaïques telles que précédemment décrites, ou obtenues par un procédé d'impression par jet d'encre selon la présente description.

Par « article », on entend tout produit commercialisable sur lequel peut être disposé un ou plusieurs dispositifs selon la présente description. En particulier un article concerne un produit solide.

Parmi les applications des dispositifs selon la description, on peut notamment citer les dispositifs autonomes, les dispositifs nomades, les dispositifs d'intérieur, les dispositifs d'extérieur.

Selon une variante, les dispositifs selon la description permettent par exemple d'ajouter une fonctionnalité et/ou de donner de l'esthétique à un appareillage existant, en particulier sans le dénaturer.

Selon une variante, les dispositifs selon la description permettent par exemple d'apporter une valeur ajoutée à des appareillages existants.

Les dispositifs selon la description permettent également par exemple de créer de nouveaux appareillages ou produits finis. Selon une variante, les dispositifs selon la description permettent par exemple de rendre autonome et esthétiques des appareillages, produit fini, ou objets actuels, comprenant des dispositifs de conversion d'énergie, et en particulier des dispositifs photovoltaïques.

Selon une variante, les dispositifs selon la description permettent par exemple d'amener des éléments de différentiation (la couleur, le facteur de forme varié et la transparence), y compris dans les domaines d'application intérieur et extérieur des dispositifs de conversion d'énergie, et en particulier des dispositifs photovoltaïques.

Selon une variante, les dispositifs selon la description permettent par exemple de personnaliser et fonctionnaliser le logo d'un client sur son produit (le logo devient photovoltaïque). Ainsi les dispositifs tels que décrits permettent par exemple la personnalisation d'un produit et d'apporter une valeur ajoutée.

Ainsi, la description concerne selon une variante un produit ou appareillage électronique ou comprenant une source d'électricité et comportant une surface disponible et/ou une surface disponible d'une certaine couleur. Un dispositif photovoltaïque structuré tridimensionnellement selon la description peut s'intégrer à un tel produit ou appareillage en y ajoutant une fonction de récupération d'énergie lumineuse pour la recharge électrique de l'appareil. La description concerne ainsi par exemple un appareil électronique portable comprenant un ou plusieurs dispositifs photovoltaïques selon la description.

La description concerne selon une variante un produit ou appareillage électronique ou comprenant une source d'électricité et comportant un motif graphique et/ou image de marque et/ou logo. Un dispositif photovoltaïque selon la description peut être structuré tridimensionnellement selon le motif graphique et/ou image de marque et/ou logo du produit ou appareillage pour une meilleure intégration tout en ajoutant une esthétique et/ou une couleur et une fonction de recharge. La description concerne ainsi un article manufacturé comprenant un dispositif photovoltaïque multicolore, comme par exemple un sac de sport.

Sur les figures :

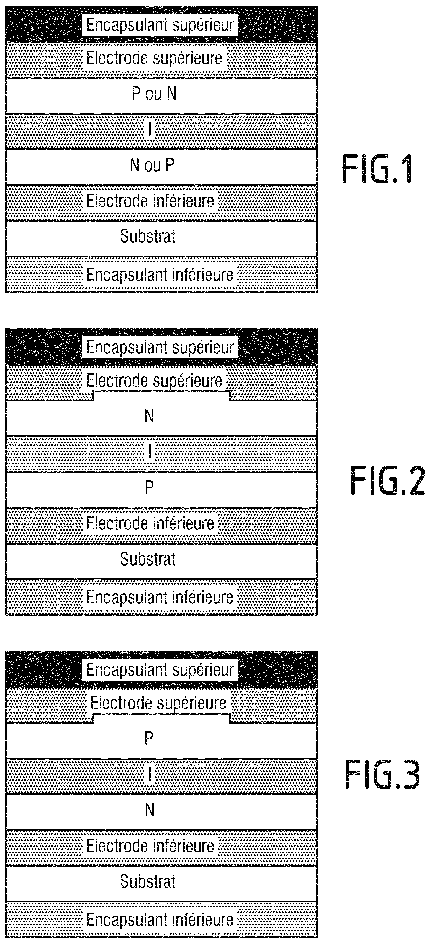

La figure 1 représente schématiquement un empilement de couches minces structuré par un procédé d'impression jet d'encre de type classique, dont l'épaisseur de chaque couche ne varie pas. Ce dispositif est monochrome.
La figure 2 représente schématiquement un empilement de couches minces structurées par un procédé jet d'encre selon la description, dont les épaisseurs varient, ici en particulier de l'électrode supérieure et de la couche N, et présente un motif multicolore.
La figure 3 représente schématiquement un empilement de couches minces structurées par un procédé jet d'encre selon la description, dont les épaisseurs varient, ici en particulier de l'électrode supérieure et de la couche P.

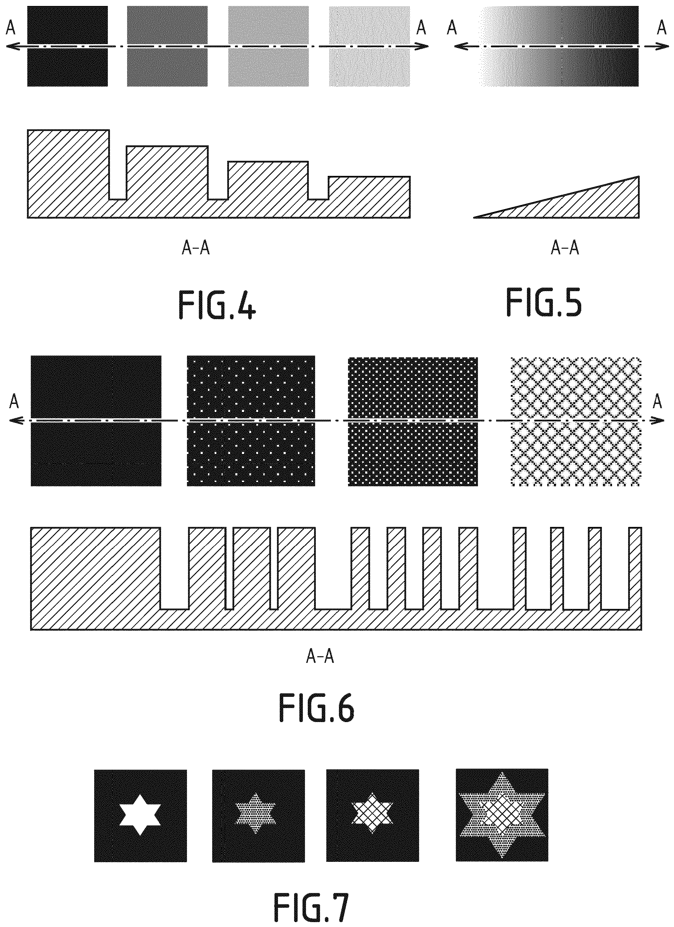

La figure 4 représente schématiquement un gradient de motifs carrés discrets, présentant une épaisseur décroissante de gauche à droite (vue de dessus et en coupe (AA)). Ainsi, pour une épaisseur maximale, par exemple pour la couleur la plus foncée (à gauche), et une épaisseur minimale pour la couleur la plus claire (ici représentée par les blancs espaçant les motifs carrés), on peut obtenir une variation de couleurs en faisant varier l'épaisseur du matériau (gradient discret d'épaisseur décroissante de gauche à droite) et obtenir un gradient de couleurs, discontinu. Selon une variante, les motifs carrés peuvent être disjoints, c'est-à-dire que la zone blanche ne comprend pas de matériau.
La figure 5 représente schématiquement un gradient d'épaisseur continu (vue de dessus et en coupe (AA)), On obtient un gradient (dégradé) de couleurs en fonction du gradient d'épaisseur du matériau.
La figure 6 représente schématiquement un gradient de motifs carrés structurés en niveaux de gris (vue de dessus et en coupe (AA)). Selon cette variante, on peut obtenir un effet visuel de gradient de couleurs en faisant varier pour chaque motif carré l'espacement entre les dépôts de gouttes de matériau. Selon le mode de réalisation représenté sur la coupe (AA) de la figure 6, le niveau de gris est obtenu avec une hauteur maximale constante. Cependant on peut faire varier, sans limite, les épaisseurs de matériau.
La figure 7 représente schématiquement, plusieurs cellules photovoltaïques, dans lesquelles une cellule photovoltaïque est représentée par un motif carré. Sur la cellule photovoltaïque à gauche, il a été déposé une électrode de forme en étoile (de forme très claire) sur la couche la plus foncée de forme carrée (par exemple une couche N ou P). L'épaisseur de l'électrode supérieure est constante et ne présente qu'une seule couleur. Le second motif en partant de la gauche représente une variation du motif d'électrode supérieure lequel comprend des motifs colorés en niveaux de gris. L'électrode supérieure présente donc des épaisseurs différentes de manière à obtenir la variation de couleurs en niveaux de gris. Le troisième motif en partant de la gauche représente une variation du motif d'électrode supérieure lequel représente un motif en niveau de gris différent de celui du second motif, selon le même principe. Le quatrième motif en partant de la gauche représente une variation multiple de couleur, par exemple par superposition de couches de différentes épaisseurs. Par exemple l'électrode supérieure de forme étoilée est identique à l'électrode supérieure selon le troisième motif en partant de la gauche (couche dite arbitrairement n), mais déposée sur une couche (n-1) formée par exemple d'un matériau semi-conducteur de type N ou P dont l'épaisseur varie de manière à former un second motif en forme étoilée (étoile la plus foncée) laquelle est déposée sur une couche (n-2) formant le motif carré le plus foncé.

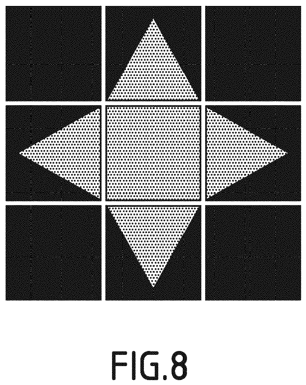

La figure 8 représente schématiquement un module d'assemblage de cellules photovoltaïques dans lequel chaque motif carré représente une cellule photovoltaïque. Le module d'assemblage comprend une ou plusieurs cellules photovoltaïques présentant des variations d'épaisseurs dans une plusieurs couches la constituant de manière à ce qu'au moins une cellule photovoltaïque présente une variation de couleurs. Le module d'assemblage des cellules photovoltaïques peuvent ainsi faire apparaître un motif, comme par exemple une étoile selon la figure 8.

Dans les exemples qui suivent et donnés à titre d'illustration, la température est mentionnée en degré Celsius, et correspond à la température ambiante (20°C), sauf indication contraire, et la pression est la pression atmosphérique (par ex. 101325 Pa) sauf indication contraire.

### Exemples

### Exemple 1 : Couches minces structurées par procédé d'impression jet d'encre

A partir d'une dispersion de nanoparticules d'oxyde de zinc (ZnO) commerciale dans du butanol, l'encre d'oxyde de zinc à imprimer a été préparée en ajustant la quantité de co-solvants, tels que par exemple glycérol, éthylène glycol et butanol (50 % dispersion mère, 24% éthylène glycol, 8% glycérol et 18% butanol, les pourcentages étant exprimés en volume par rapport au volume total), à base de glycols et d'alcools pour obtenir une viscosité de l'encre dans la gamme de 8-15cp. Ensuite, les essais d'impression ont été réalisés à partir d'une plateforme d'impression Ardeje ORIGIND100 en utilisant un module d'impression DOD piézoélectrique contenant Ardeje HA-5. Après filtration, l'encre ZnO formulée a été versée dans le réservoir d'encre du dispositif d'impression ORIGIND100. La plateforme d'impression a été configurée en fichier de fabrication de la couche et la stratégie d'impression a été chargée. En particulier, le dépôt de la couche par impression a été réalisé avec des résolutions carrées de 720×720dpi² et un volume de gouttes de 10pL.Un nombre de passages croissant de 1 à 5 a permis de structurer une couche avec différents niveaux d'épaisseurs comprises entre 20 à 90nm.
Selon le même principe, on peut ajouter des additifs liquides pour favoriser la conductivité et mouillabilité sans affecter les propriétés de rhéologie et de travail d'extractions du matériau PEDOT-PSS. A partir de solution de polyéthylène dioxythiophene dopé au polystyrène sulfonate (PEDOT-PSS) commerciale, l'encre PEDOT-PSS à imprimer a été préparée en ajustant la quantité de co-solvants à base d'éthylène glycol et de glycérol pour obtenir une viscosité de l'encre dans la gamme de 8-15cp. Ensuite, les essais d'impression ont été réalisés à partir d'une plateforme d'impression Ardeje ORIGIND100 en utilisant un module d'impression DOD piézoélectrique contenant Ardeje HA-5. Après filtration, l'encre PEDOT-PSS formulée a été versée dans le réservoir d'encre du dispositif d'impression ORIGIND 100. La plateforme d'impression a été configurée en fichier de fabrication de la couche et la stratégie d'impression a été chargée. En particulier, des résolutions carrées de 1440×1440dpi² ayant un tramage des motifs et avec un volume de gouttes de 40pL, et un nombre de passe croissant de 1 a 3p ont été utilisé pour structurer différentes épaisseurs de 100 à 300nm.

### Exemple 2 : Couche ZnO de type N structurée tridimensionnellement par impression jet d'encre

On a imprimé par jet d'encre une couche d'oxyde de zinc (ZnO) pour former une cellule photovoltaïque organique ayant la structure verre/ITO/PEDOT:PSS/PTB7-PCBM/ZnO/AI. Par analogie, à la figure générique (Fig. 1), les couches PEDOT-PSS et ZnO constituent respectivement la couche P et N tandis que la couche formée du mélange de matériaux actifs PTB7 et PCBM forment la couche photoactive I.

Les couches verre/ITO/PEDOT:PSS/PTB7-PCBM sont préparées selon un procédé de l'état de la technique. Chaque couche comprend une épaisseur constante sur toute leur surface.

Cet empilement de couches est disposé dans un dispositif d'impression numérique jet d'encre. Le dispositif d'impression jet d'encre comprend un réservoir d'encre comprenant de l'oxyde de zinc (ZnO). On dépose par impression jet d'encre une couche d'oxyde de zinc (ZnO) sur la couche PTB7-PCBM avec une variation d'épaisseur selon les motifs prédéfinis. La figure 2 représente schématiquement une telle structure. On prend représenter ainsi des motifs diverses comme ceux par exemple illustrés aux figures 4 à 7 en faisant varier l'épaisseur d'une même couche.

Ainsi, selon une variante, il a été déposé par impression jet d'encre une couche d'oxyde de zinc (ZnO) sur la couche PTB7-PCBM avec une variation d'épaisseur selon les motifs prédéfinis de la figure 4, représentant un gradient discret de quatre motifs carrés ayant quatre épaisseurs différentes.

Selon une variante, on a déposé par impression jet d'encre une couche d'oxyde de zinc (ZnO) sur la couche PTB7-PCBM selon le motif prédéfini de la figure 5 c'est-à-dire avec un gradient continu d'épaisseur.

Selon une variante, on a déposé par impression jet d'encre une couche d'oxyde de zinc (ZnO) sur la couche PTB7-PCBM selon le motif prédéfini de la figure 6 c'est-à-dire structuré en niveau de gris avec des épaisseurs de ZnO différentes.

On a réalisé des essais préalables associant les composantes CIELAB d'une couleur en fonction de l'épaisseur du matériau. Ainsi pour une épaisseur de couche d'oxyde de zinc, on y associe une couleur déterminée par ses composantes CIELAB. Après solidification de la couche d'oxyde de zinc déposée/imprimée, on procède à une métallisation des cellules photovoltaïques organiques. L'épaisseur de la couche d'oxyde de zinc déposée varie de 20 à 90nm.

Le dispositif photovoltaïque résultant permet de visualiser différentes couleurs générées par le motif structuré de la couche d'oxyde de zinc.

Les dispositifs photovoltaïques ont été caractérisés et ont permis de mesurer des efficacités énergétiques comprises entre 3,5 et 4 %.

Ainsi, on peut préparer des dispositifs de conversion d'énergie, et en particulier des dispositifs photovoltaïques multicolores.

### Exemple 3 : Couche PEDOT-PSS de type P structurée tridimensionnellement par impression jet d'encre

On a imprimé par jet d'encre une couche de PEDOT:PSS de type P pour former une cellule photovoltaïque organique ayant la structure ITO/ZnO/PTB7-PCBM/PEDOT:PSS/Ag. Par analogie, à la figure générique (Fig. 1), les couches ZnO et PEDOT-PSS constituent respectivement la couche N et P tandis que la couche formée du mélange de matériaux actifs PTB7 et PCBM forment la couche photoactive I.

Les couches ITO/ZnO/PTB7-PCBM sont préparées selon un procédé de l'état de la technique. Chaque couche comprend une épaisseur constante sur toute leur surface.

Cet empilement de couches est disposé dans un dispositif d'impression numérique jet d'encre. Le dispositif d'impression jet d'encre comprend un réservoir d'encre comprenant du PEDOT-PSS On dépose par impression jet d'encre une couche de PEDOT-PSS sur la couche PTB7-PCBM avec des épaisseurs différentes selon un motif prédéfini.

Ainsi, selon une variante, il a été déposé par impression jet d'encre une couche de PEDOT-PSS sur la couche PTB7-PCBM avec une variation d'épaisseur selon les motifs prédéfinis de la figure 4, représentant un gradient discret de quatre motifs carrés ayant quatre épaisseurs différentes.

Selon une variante, on a déposé par impression jet d'encre une couche de PEDOT-PSS sur la couche PTB7-PCBM selon le motif prédéfini de la figure 5 c'est-à-dire avec un gradient continu d'épaisseur.

Selon une variante, on a déposé par impression jet d'encre une couche de PEDOT-PSS sur la couche PTB7-PCBM selon le motif prédéfini de la figure 6 c'est-à-dire structuré en niveau de gris avec des épaisseurs de PEDOT-PSS différentes.

On a réalisé des essais préalables associant les composantes CIELAB d'une couleur en fonction de l'épaisseur du matériau PEDOT:PSS. Ainsi pour une épaisseur de couche de PEDOT:PSS, on y associe une couleur déterminée par ses composantes CIELAB. À titre d'exemple, l'échiquier les figures 2 à 4 présentent les composantes CIELAB pour les épaisseurs respectivement de 100 nm, 200 nm et 300 m. Après solidification de la couche de PEDOT:PSS déposée/imprimée, on procède à une métallisation des cellules photovoltaïques organiques. L'épaisseur de la couche de PEDOT:PSS déposée varie de 100 à 300nm.

Le dispositif photovoltaïque résultant permet de visualiser différentes couleurs générées par le motif structuré de la couche de PEDOT:PSS.

Le dispositif photovoltaïque a été caractérisé et a permis de mesurer des efficacités énergétiques inférieures à 1%.

Ainsi, on peut préparer des dispositifs de conversion d'énergie, et en particulier des dispositifs photovoltaïques multicolores.

### Exemple 4 : Dispositif OPV structuré tridimensionnellement par procédé jet d'encre

Un dispositif OPV (cellules photovoltaïque organique) a été réalisé de manière classique par empilement de couches (par exemple selon l'exemple 2 ou 3, avec ou sans variation de l'épaisseur des couches semi-conductrice N et/ou P). En revanche, la couche d'électrode supérieure a été préparée par un procédé d'impression jet d'encre avec une variation d'épaisseur de la couche d'électrode. En utilisant une variation de son épaisseur, l'électrode supérieure peut être structurée en jouant sur des niveaux de gris entre opacité et transparence pour produire des cellules photovoltaïques de manière à former des motifs multicolores, par exemple présentant les formes selon la figure 7.

### Exemple 5 : Module de cellules photovoltaïques structuré tridimensionnellement par procédé jet d'encre

Un module d'assemblage de cellules photovoltaïques peut être préparé par assemblage de différentes cellules photovoltaïques telles qu'obtenues selon l'exemple 4, chaque cellule pouvant être structurée selon un motif différent. Une ou plusieurs cellules photovoltaïques peuvent ne pas comprendre de variations d'épaisseur, mais au moins une cellule photovoltaïque comprend une variation d'épaisseur d'au moins une couche. Le motif est créé par l'ensemble des cellules structurées juxtaposées. On peut ainsi par exemple préparer un motif selon la figure 8, en forme étoilée.

### Exemple 6 : Encapsulant de dispositif photovoltaïque structuré tridimensionnellement par procédé jet d'encre

Un encapsulant face avant et/ou face arrière appliqué pour protéger les dispositifs de l'exemple 4 et 5 peut être structuré tridimensionnellement ou une couche structurée peut-être réalisée dessus par impression d'un matériau transparent, semi-transparent ou opaque. Il est ainsi possible d'imprimer une couche structurée à partir d'un matériau semi-transparent coloré afin de faire apparaitre des variations de propriétés optiques, en particulier la densité optique, et ainsi réaliser un dispositif multicolore.

### Exemple 7 : Dispositif photovoltaïque structuré et intégré sur produit

Le dispositif tel que décrit peut être utilisé pour faire un support de communication (par exemple un élément graphique de type logo photovoltaïque sur des produits de packaging de luxe ou de la bagagerie de sport).

Un dispositif photovoltaïque ou un module d'assemblage de cellules photovoltaïques structuré selon l'élément graphique souhaité peut être intégré sur un bagage coloré.

Un dispositif photovoltaïque flexible ou un module d'assemblage de cellules photovoltaïques structuré flexible selon l'élément graphique souhaité peut être intégré sur un packaging/emballage comme par exemple un packaging/emballage de luxe, par exemple en forme de pavé ou de cylindre.

## Revendications

1. Dispositif photovoltaïque tridimensionnel de conversion d'énergie comprenant plusieurs couches tridimensionnelles, dont une couche tridimensionnelle présente une épaisseur variable, ledit dispositif tridimensionnel présentant plusieurs couleurs, la couleur variant en fonction de l'épaisseur d'une ou plusieurs couches présentes, le dispositif comprenant au moins une couche photo-active, une couche formant une hétérojonction P avec la couche photoactive et une couche formant une hétérojonction N avec la couche photoactive, la couche photoactive étant formée d'une hétérojonction planaire de matériaux semi-conducteurs organiques donneur et accepteur d'électrons ; ou bien est formée d'un mélange de matériaux semi-conducteurs organiques donneur et accepteur d'électrons ; ou bien est formée de bicouche ou de mélange de matériaux hybrides organique-inorganiques, et la couche dont l'épaisseur varie étant choisie parmi la couche photo-active, la couche formant hétérojonction P et la couche formant hétérojonction N, et forme un filtre interférentiel structuré tridimensionnellement avec une ou plusieurs couches adjacentes.

2. Dispositif, selon la revendication 1, dans lequel la variation d'épaisseur comprend un ou plusieurs gradients d'épaisseur ou différents niveaux d'épaisseurs au sein d'une ou plusieurs couches.

3. Dispositif, selon la revendication 1 ou 2, dans lequel la variation d'épaisseur est localisée hors d'une zone de conversion électrique.

4. Dispositif, selon l'une quelconque des revendications 1 à 3, comprenant une couche d'oxyde métallique comprenant une ou plusieurs variations d'épaisseur

5. Dispositif, selon l'une quelconque des revendications 1 à 4, dans lequel le substrat est un matériau rigide ou flexible ; semi-transparent ou transparent ou opaque.

6. Dispositif, selon l'une quelconque des revendications 1 à 5, dans lequel :
- la couche de type P est une couche d'un ou plusieurs matériaux choisis parmi les oxydes métalliques tel le V2O5, WO3, MoOx, MoO3 ; les polymères conducteurs organiques tel le mélange de poly(3,4-éthylènedioxythiophène) et de polystyrène sulfonate) de sodium; et le spiro-OMeTAD ; et/ou
- la couche de type N est une couche d'un ou plusieurs matériaux choisis parmi les oxydes métalliques ZnO, AZO, TiO2, TiOx, NiO, Cs2CO3 ; les oxydes de graphène ; et les matériaux organiques.

7. Procédé d'impression par jet d'encre comprenant l'impression par jet d'encre d'une couche tridimensionnelle d'un dispositif photovoltaïque tridimensionnel de conversion d'énergie, ledit dispositif photovoltaïque tridimensionnel comprenant plusieurs couches tridimensionnelles, dont une couche présente une épaisseur variable, ledit dispositif tridimensionnel présentant plusieurs couleurs, la couleur variant en fonction de l'épaisseur d'une ou plusieurs couches présentes, le dispositif comprenant au moins une couche photo-active, une couche formant hétérojonction P avec la couche photoactive et une couche formant hétérojonction N avec la couche photoactive, la couche photoactive étant formée d'une hétérojonction planaire de matériaux semi-conducteurs organiques donneur et accepteur d'électrons ; ou bien est formée d'un mélange de matériaux semi-conducteurs organiques donneur et accepteur d'électrons ; ou bien est formée de bicouche ou de mélange de matériaux hybrides organique-inorganiques, et la couche dont l'épaisseur varie étant choisie parmi la couche photo-active, la couche formant hétérojonction P et la couche formant hétérojonction N, et forme un filtre interférentiel structuré tridimensionnellement avec une ou plusieurs couches adjacentes.

8. Procédé, selon la revendication 7, dans lequel la forme et la couleur du dispositif photovoltaïque sont définies dans un repère XYZ, ledit procédé comprenant :
(i) le positionnement d'un module d'impression selon un référentiel XYZ ;
(ii) éventuellement le positionnement dans le référentiel XYZ d'une ou plusieurs couches déjà empilées pour l'impression d'une ou plusieurs couches par jet d'encre ;
(iii) l'impression par jet d'encre d'une couche choisie parmi la couche photo-active, la couche formant hétérojonction P et la couche formant hétérojonction N dont l'épaisseur z varie en fonction de la position du module d'impression dans le référentiel XYZ ;
(iv) l'obtention du dispositif photovoltaïque dans lequel la couleur varie en fonction de l'épaisseur z d'une couche imprimée.

9. Procédé, selon la revendication 7 ou 8, dans lequel l'épaisseur d'une couche est fonction du volume de gouttes, de la résolution, du tramage, du mode d'impression, du mode de déplacement de la tête d'impression, du nombre de passes, et de l'une quelconque de leurs combinaisons.

10. Module d'assemblage de plusieurs dispositifs de conversion d'énergie, **caractérisé en ce qu'**il comprend un ou plusieurs dispositifs photovoltaïques de conversion d'énergie, tels que définis selon l'une quelconque des revendications 1 à 6, ou obtenus par un procédé d'impression par jet d'encre tel que défini selon l'une quelconque des revendications 7 à 9.

11. Article comprenant un ou plusieurs dispositifs photovoltaïques de conversion d'énergie, tels que définis selon l'une quelconque des revendications 1 à 6, ou obtenus par un procédé d'impression par jet d'encre tel que défini selon l'une quelconque des revendications 7 à 9.

## Patentansprüche

1. Dreidimensionale photovoltaische Energieumwandlungsvorrichtung mit mehreren dreidimensionalen Schichten, von denen eine dreidimensionale Schicht eine variable Dicke aufweist, wobei die dreidimensionale Vorrichtung mehrere Farben aufweist, wobei sich die Farbe in Abhängigkeit von der Dicke einer oder mehrerer vorhandenen Schichten ändert. Die Vorrichtung umfasst mindestens eine photoaktive Schicht, eine Schicht, die einen N-Heteroübergang mit der photoaktiven Schicht bildet, und eine Schicht, die einen P-Heteroübergang mit der photoaktiven Schicht bildet, wobei die photoaktive Schicht aus einem planaren Heteroübergang aus elektronenabgebenden und elektronenaufnehmenden organischen Halbleitermaterialien gebildet wird: oder aus einer Mischung aus organischen Halbleitermaterialien mit Elektronendonator und -akzeptor gebildet wird: oder aus einer Doppelschicht oder einer Mischung aus organisch-anorganischen Hybridmaterialien gebildet wird, und die Schicht, deren Dicke variiert, aus der photoaktiven Schicht, der P-Heteroübergangsschicht und der N-Heteroübergangsschicht ausgewählt wird, und mit einer oder mehreren benachbarten Schichten einen dreidimensional strukturierten Interferenzfilter bildet.

2. Vorrichtung nach Anspruch 1, wobei die Dickenvariation einen oder mehrere Dickengradienten oder unterschiedliche Dickenstufen innerhalb einer oder mehrerer Schichten umfasst.

3. Vorrichtung nach Anspruch 1 oder 2, wobei die Dickenänderung außerhalb eines elektrischen Umwandlungsbereichs lokalisiert ist.

4. Vorrichtung, nach einem der Ansprüche 1 bis 3, mit einer Metalloxidschicht, die eine oder mehrere Dickenvariationen aufweist

5. Vorrichtung, nach einem der Ansprüche 1 bis 4, wobei das Substrat ein starres oder flexibles Material ist; halbtransparent oder transparent oder undurchsichtig.

6. Vorrichtung nach einem der Ansprüche 1 bis 5, wobei:
- die Schicht vom Typ P eine Schicht aus einem oder mehreren Materialien ist, die ausgewählt sind aus Metalloxiden wie V2O5, WO3, MoOx, MoO3; organischen leitfähigen Polymeren wie der Mischung aus Natriumpoly(3,4-ethylendioxythiophen) und Natriumpolystyrolsulfonat); und Spiro-OMeTAD: und/oder
- die Schicht vom Typ N eine Schicht aus einem oder mehreren Materialien ist, die aus den Metalloxiden ZnO, AZO, TiO2, TiOx, NiO, Cs2CO3; Graphenoxiden; und organischen Materialien ausgewählt sind.

7. Tintenstrahldruckverfahren, umfassend das Tintenstrahldrucken einer dreidimensionalen Schicht einer dreidimensionalen photovoltaischen Energieumwandlungsvorrichtung, wobei die dreidimensionale photovoltaische Vorrichtung eine Vielzahl von dreidimensionalen Schichten umfasst, von denen eine Schicht eine variable Dicke aufweist, wobei die dreidimensionale Vorrichtung mehrere Farben aufweist, wobei die Farbe in Abhängigkeit von der Dicke der einen oder anderen Schicht variiert. Die Vorrichtung umfasst mindestens eine photoaktive Schicht, eine Schicht, die einen Heteroübergang P mit der photoaktiven Schicht bildet, und eine Schicht, die einen Heteroübergang N mit der photoaktiven Schicht bildet. Die photoaktive Schicht besteht aus einem planaren Heteroübergang aus organischen Halbleitermaterialien mit Elektronendonator und -akzeptor; oder aus einer Mischung aus organischen Halbleitermaterialien mit Elektronendonator und - akzeptor; oder aus einer Doppelschicht oder einer Mischung aus organisch-anorganischen Hybridmaterialien, und die Schicht, deren Dicke variiert, ist aus der photoaktiven Schicht, der P-Heteroübergangsschicht und der N-Heteroübergangsschicht ausgewählt und bildet mit einer oder mehreren benachbarten Schichten einen dreidimensional strukturierten Interferenzfilter.

8. Verfahren nach Anspruch 7, bei dem die Form und die Farbe der photovoltaischen Vorrichtung in einem XYZ-Koordinatensystem definiert werden, wobei das Verfahren umfasst:
(i) die Positionierung eines Druckmoduls gemäß einem XYZ-Referenzsystem:
(ii) gegebenenfalls das Positionieren einer oder mehrerer bereits gestapelter Schichten im XYZ-Referenzsystem für das Bedrucken einer oder mehrerer Schichten mit Tintenstrahldruckern;
(iii) Tintenstrahldrucken einer Schicht, die aus der photoaktiven Schicht, der P-Heteroübergangsschicht und der N-Heteroübergangsschicht ausgewählt ist, deren Dicke z sich in Abhängigkeit von der Position des Druckmoduls in der XYZ-Richtung ändert;
(iv) das Erhalten der photovoltaischen Vorrichtung, bei der sich die Farbe in Abhängigkeit von der Dicke z einer gedruckten Schicht ändert.

9. Verfahren nach Anspruch 7 oder 8, bei dem die Dicke einer Schicht vom Tropfenvolumen, der Auflösung, der Rasterung, dem Druckmodus, dem Bewegungsmodus des Druckkopfes, der Anzahl der Durchgänge und einer beliebigen Kombination davon abhängt.

10. Modul zum Zusammenbau mehrerer Energieumwandlungsvorrichtungen, **dadurch gekennzeichnet, dass** es eine oder mehrere photovoltaische Energieumwandlungsvorrichtungen umfasst, wie sie nach einem der Ansprüche 1 bis 6 definiert sind oder durch ein Tintenstrahldruckverfahren, wie nach einem der Ansprüche 7 bis 9 definiert, erhalten wurden.

11. Artikel mit einer oder mehreren photovoltaischen Energieumwandlungsvorrichtungen, wie nach einem der Ansprüche 1 bis 6 definiert oder durch ein Tintenstrahldruckverfahren, wie nach einem der Ansprüche 7 bis 9 definiert, erhalten.

## Claims

1. A three-dimensional photovoltaic energy conversion device comprising a plurality of three-dimensional layers, one three-dimensional layer of which has a variable thickness, said three-dimensional device having a plurality of colours, the colour varying as a function of the thickness of one or more layers present, the device comprising at least one photoactive layer, a layer forming a P heterojunction with the photoactive layer and a layer forming an N heterojunction with the photoactive layer, the photoactive layer being formed by a planar heterojunction of electron-donor and electron-acceptor organic semiconductor materials; or is formed from a mixture of electron-donor and electron-acceptor organic semiconductor materials; or is formed of a bilayer or mixture of organic-inorganic hybrid materials, and the layer of varying thickness is selected from the photoactive layer, the P-heterojunction layer and the N-heterojunction layer, and forms a three-dimensionally structured interference filter with one or more adjacent layers.

2. The device according to claim 1, wherein the thickness variation comprises one or more thickness gradients or different thickness levels within one or more layers.

3. The device according to claim 1 or 2, wherein the thickness variation is located outside an electrical conversion zone.

4. The device according to any one of claims 1 to 3, comprising a metal oxide layer comprising one or more thickness variations

5. The device according to any one of claims 1 to 4, in which the substrate is a rigid or flexible material; semi-transparent or transparent or opaque.

6. The device according to any one of claims 1 to 5, wherein:
- the P-type layer is a layer of one or more materials selected from metal oxides such as V2O5, WO3, MoOx, MoO3; organic conducting polymers such as a mixture of poly(3,4-ethylenedioxythiophene) and sodium polystyrene sulphonate); and spiro-OMeTAD; and/or
- the N-type layer is a layer of one or more materials selected from metal oxides ZnO, AZO, TiO2, TiOx, NiO, Cs2CO3; graphene oxides; and organic materials.

7. An inkjet printing method comprising the inkjet-printing of a three-dimensional layer of a three-dimensional photovoltaic energy conversion device, said three-dimensional photovoltaic device comprising a plurality of three-dimensional layers, of which one layer has a variable thickness, said three-dimensional device having a plurality of colours, the colour varying as a function of the thickness of one or more layers present, the device comprising at least one photoactive layer, a layer forming a P heterojunction with the photoactive layer and a layer forming an N heterojunction with the photoactive layer, the photoactive layer being formed by a planar heterojunction of electron-donor and electron-acceptor organic semiconductor materials: or is formed from a mixture of electron-donor and electron-acceptor organic semiconductor materials: or is formed of a bilayer or mixture of organic-inorganic hybrid materials, and the layer of varying thickness is selected from the photoactive layer, the P-heterojunction layer and the N-heterojunction layer, and forms a three-dimensionally structured interference filter with one or more adjacent layers.

8. The method according to claim 7, wherein the shape and colour of the photovoltaic device are defined in an XYZ reference frame, said method comprising:
(i) the positioning of a print module according to an XYZ reference system;
(ii) optionally the positioning in the XYZ reference frame of one or more already-stacked layers for the inkjet printing of one or more layers;
(iii) the inkjet-printing of a layer selected from the photoactive layer, the P-heterojunction layer and the N-heterojunction layer whose thickness z varies as a function of the position of the printing module in the XYZ reference frame;
(iv) obtaining the photovoltaic device in which the colour varies as a function of the thickness z of a printed layer.

9. The method according to claim 7 or 8, wherein the thickness of a layer is a function of drop volume, resolution, screening, print mode, print head movement mode, number of passes, and any combination thereof.

10. A module for assembling a plurality of energy conversion devices, **characterised in that** it comprises one or more photovoltaic energy conversion devices, as defined according to any one of claims 1 to 6, or obtained by an inkjet printing method as defined according to any one of claims 7 to 9.

11. An article comprising one or more photovoltaic energy conversion devices as defined in any one of claims 1 to 6, or obtained by an inkjet printing method as defined in any one of claims 7 to 9.
